# EUROPEAN PATENT APPLICATION

(11) **EP 1 811 554 A2**
(43) Date of publication of application: **25.07.2007**
(21) Application number: 07000896.6
(22) Date of filing: 17.01.2007
(51) Int. Cl.: H01L 21/56, H01L 23/29

(54) **Foamable underfill encapsulant**

(30) Priority: 18.01.2006 US 333940
(71) Applicant: National Starch and Chemical Investment Holding Corporation, New Castle, Delaware 19720 (US)
(72) Inventor: Shah, Jayesh, Plaistow, New Hampshire 03865 (US); Morganelli, Paul, Upton, Massachusetts 01568 (US); Peard, David, Windham, New Hampshire 03087 (US)
(74) Representative: Held, Stephan

(57) **Abstract**

A thermoplastic or thermosetting B-stageable or pre-formed film underfill encapsulant composition that is used in the application of electronic components to substrates. The composition comprises a resin system comprising thermoplastic or thermally curable resin, an expandable microsphere, a solvent, and optionally a catalyst. Various other additives, such as adhesion promoters, flow additives and rheology modifiers may also be added as desired. The underfill encapsulant may be dried or B-staged to provide a coating on the substrate or component that is smooth and non-tacky. In an alternative embodiment, the underfill encapsulant is a pre-formed film. In both embodiments the expandable filler material expands upon the application of higher temperatures to form a closed-cell foam structure in the desired portion of the assembly.

## Description

### RELATED APPLICATIONS

The present application is a continuation-in-part of copending United States Patent Application Serial Number 10/444,603, filed on May 23, 2003.

### FIELD OF THE INVENTION

The present invention is related to an underfill encapsulant containing one or more expandable fillers and a method for its application to electronic devices.

### BACKGROUND OF THE INVENTION

This invention relates to underfill encapsulant compounds containing one or more expandable fillers. The encapsulants are used to protect and reinforce the interconnections between an electronic component and a substrate in a microelectronic device. Microelectronic devices contain multiple types of electrical circuit components, mainly transistors assembled together in integrated circuit (IC) chips, but also resistors, capacitors, and other components. These electronic components are interconnected to form the circuits, and eventually are connected to and supported on a carrier or a substrate, such as a printed wire board. The integrated circuit component may comprise a single bare chip, a single encapsulated chip, or an encapsulated package of multiple chips. The single bare chip can be attached to a lead frame, which in turn is encapsulated and attached to the printed wire board, or it can be directly attached to the printed wire board. These chips are originally formed as a semiconductor wafer containing multiple chips. The semiconductor wafer is diced as desired into individual chips or chip packages.

Whether the component is a bare chip connected to a lead frame, or a package connected to a printed wire board or other substrate, the connections are made between electrical terminations on the electronic component and corresponding electrical terminations on the substrate. One method for making these connections uses polymeric or metallic material that is applied in bumps to the component or substrate terminals. The terminals are aligned and contacted together and the resulting assembly is heated to reflow the metallic or polymeric material and solidify the connection.

During its normal service life, the electronic assembly is subjected to cycles of elevated and lowered temperatures. Due to the differences in the coefficient of thermal expansion for the electronic component, the interconnect material, and the substrate, this thermal cycling can stress the components of the assembly and cause it to fail. To prevent the failure, the gap between the component and the substrate is filled with a polymeric encapsulant, hereinafter called underfill or underfill encapsulant, to reinforce the interconnect material and to absorb some of the stress of the thermal cycling. Two prominent uses for underfill technology are for reinforcing packages known in the industry as chip scale packages (CSP), in which a chip package is attached to a substrate, and flip-chip packages in which a chip is attached by an array of interconnections to a substrate. Another function of the underfill is to reinforce the component against mechanical shock such as impact or vibration. This is especially important for durability in portable electronic devices such as cellular telephones and the like that may be expected to be accidentally dropped or otherwise stressed during use.

In conventional capillary flow underfill applications, the underfill dispensing and curing takes place after the reflow of the metallic or polymeric interconnect. In this procedure, flux is initially applied on the metal pads on the substrate. Next, the chip is placed on the fluxed area of the substrate, on top of the soldering site. The assembly is then heated to allow for reflow of the solder joint. At this point, a measured amount of underfill encapsulant material is dispensed along one or more peripheral sides of the electronic assembly and capillary action within the component-to-substrate gap draws the material inward. After the gap is filled, additional underfill encapsulant may be dispensed along the complete assembly periphery to help reduce stress concentrations and prolong the fatigue life of the assembled structure. The underfill encapsulant is subsequently cured to reach its optimized final properties. A drawback of capillary underfill is that its application requires several extra steps and is thus not economical for high volume manufacturing.

Recently, attempts have been made to streamline the process and increase efficiency by the use of no flow underfill and coating the no flow underfill directly on the assembly site before the placement of the component on that site. After the component is placed it is soldered to the metal connections on the substrate by passing the entire assembly through a reflow oven. During the process the underfill fluxes the solder and metal pads to form the interconnect joints between the interconnect, the substrate and the underfill. One limitation of the no flow underfill process is that the substrate and components must be pre-dried to avoid excessive voiding within the underfill that will lead to solder extrusion that ultimately may create a short-circuit to another connection. Thus, the substrates must be dried before assembly and then stored in dry storage. This process is unwieldy for high volume manufacturers.

In order to be useful as a pre-applied underfill encapsulant, the underfill must have several important properties. First, the material must be easy to apply uniformly so that the entire assembly has a consistent coating. The underfill encapsulant must be either B-stageable, which means that the underfill must be solidified after its placement on a CSP component to provide a smooth, non-tacky coating with minimal residual solvent, or capable of being formed into a film. Further, there is often great difficulty during manufacturing in uniformly applying conventional underfill materials.

The B-stage process usually occurs at a temperature lower than about 150 °C without prematurely curing the underfill encapsulant. The final curing of the underfill encapsulant must be delayed until after the solder fluxing (in the situation that solder is the interconnect material) and interconnection, which occurs at a temperature of 183 °C in the case of tin/lead eutectic solder. The final curing of the underfill should occur rapidly after the solder bump flow and interconnection. During this final attachment of the individual chips to a substrate, the underfill encapsulant must flow in order to enable fillet formation and provide good adhesion between the chip, or chip passivation layer, the substrate, or the solder mask, and the solder joints.

### SUMMARY OF THE INVENTION

The invention relates to a B-stageable or pre-formed underfill encapsulant composition that is used in the application of electronic components, most commonly chip scale packages (CSP's) to substrates. The composition comprises a thermoplastic resin system comprising a phenoxy resin, an expandable filler material, such as expandable polymer spheres, a solvent, optionally an epoxy resin such as higher molecular weight epoxy resin, optionally an imidazole-anhydride catalyst or comparable latent catalyst, and optionally, fluxing agents and/or wetting agents. Various other additives, such as adhesion promoters, flow additives and rheology modifiers may also be added as desired. The underfill encapsulant may be B-stageable to provide a coating on the on the substrate or component that is smooth and non-tacky. In an alternative embodiment, the underfill encapsulant is a pre-formed film. In both embodiments the expandable filler material expands upon the application of higher temperatures to form a closed-cell foam structure in the desired portion of the assembly. The underfill may be applied selectively to parts of the CSP, for example to the perimeter, as discrete dots between the solder bumps or in a grid pattern between the rows of solder bumps.

### BRIEF DESCRIPTION OF THE DRAWINGS

Figure 1 is a diagram of an assembly having foamable underfill before and after reflow.
Figure 2 is a diagram of an assembly having foamable underfill around its perimeter before and after reflow.

### DETAILED DESCRIPTION OF THE INVENTION

The resins used in the underfill encapsulant composition of the present invention may be thermoplastics, or curable compounds. The latter means that they are capable of polymerization. As used in this specification, to cure will mean to polymerize, with cross-linking. Cross-linking, as understood in the art, is the attachment of two-polymer chains by bridges of an element, a molecular group, or a compound, and in general takes place upon heating.

Thermoplastic or thermoset resin systems containing expandable fillers may be formulated and pre-applied on electronic components such as surface mount components and area array devices such as CSPs or BGA's, either as a B-stageable liquid material or as a laminated film. The resin systems of this invention may also be utilized on a wafer, panel or component level. In these situations, the expandable fillers remain unexpanded after the initial application of the encapsulant to the component. The component containing the encapsulant is then placed on a printed circuit board using solder paste and/or flux and passed through a reflow oven wherein the components electrically connect to the circuit. During the reflow process the unexpanded polymer spheres expand and fill the desired area, frequently the area between the solder joints, with a closed-cell foam structure.

The resin systems of the present invention comprise a high molecular weight solid component, with the molecular weight being sufficiently high so as to allow for film forming. The high molecular weight solid may be obtained via the conversion of a low molecular weight epoxy resin that is B-staged with heat into a high molecular weight epoxy resin via the use of latent curatives. The high molecular weight component may also be obtained by incorporating an epoxy resin within a separate material, such as a reactive acrylic, which can be B-staged with UV light. Further, the high molecular weight component may be obtained by preparing a solution of a thermoplastic polymer and B-staging by removing the solvent in a subsequent drying step. Molecular weights that are sufficiently high are those in the range of greater than about 3,000, with molecular weights in the range of greater than about 10,000 being more preferred and molecular weights in the range of greater than about 40,000 being most preferred.

Ingredients of the underfill encapsulant composition of the present invention include a blend of one or more phenoxy resins, a thermoplastic or thermosetting polymer capable of expanding at elevated temperatures, in the case of a thermosetting polymer a catalyst such as an imidazole-anhydride adduct, and optionally one or more solvents. Optionally, fluxing agents, air release agents, flow additives, adhesion promoters, rheology modifiers, surfactants, inorganic fillers and other ingredients may be included. The ingredients are specifically chosen to obtain the desired balance of properties for the use of the particular resins. A solvent is chosen to dissolve the resin(s) and thus make the composition into a paste form with proper viscosity for application as a liquid via spin coating, screen printing or stencil printing on the CSP panel. The underfill system may also be applied as a solid pre-formed laminated film.

In a preferred embodiment, the composition contains a thermoplastic polymer, solvent and is B-stageable, i.e., the composition is capable of an initial solidification that produces a smooth, non-tacky coating on the electronic component to be attached to a substrate. The B-stage solidification preferably occurs at a temperature in the range of about 60 °C to about 150 °C. At this temperature the expandable fillers do not expand. After the B-stage process, a smooth, non-tacky solid coating is obtained on the CSP panel to ensure the clean dicing of the CSP panel into individual CSPs. The final solidification occurs during exposure to the solder reflow temperature profile. The expandable fillers will expand within typical solder reflow conditions. In the case of tin/lead eutectic solder, the formation of the interconnections occurs at a temperature above the melting point of the solder, which is 183 °C. In an alternative preferred embodiment, the composition is a pre-formed laminated film. The film is a phenoxy resin, but thermoplastic polyesters, polyamides, polyurethanes, polyolefins or the like, compounded with expandable spheres, may be expected to work.

Examples of phenoxy resins suitable for use in the present underfill composition include high molecular weight solids. Examples are resins available from Inchem under the tradenames PKHC, PKHH, HC and HH, or blends of these with liquid epoxy resins.

The expandable fillers utilized in the underfill must be sufficient to produce a closed-cell foam that will fill the desired area. Frequently, the desired area is either the entire surface area surrounding the solder joints or a line around the perimeter of the assembly. A preferred expandable filler material is expandable thermoplastic micro balloons, such as are commercially available from Akzo Nobel (Sweden) as 098 DUX 120, 091 DU, 092 DU, and 095 DU. These microspheres are filled with isooctane and are stable at lower temperatures. The micro balloons do not expand at temperatures below 160C, the temperature at which B-staging of the underfill occurs. The microspheres expand at temperatures above 160C and reach their maximum expansion at approximately 220C which is typically the highest peak temperature for curing in eutectic soldering processes. Upon expansion the microspheres create a closed-cell structure within the underfill matrix. Other materials that may be expected to provide the foam structure include chemical blowing agents.

A solvent is utilized to modify the viscosity of the composition. Preferably, the solvent will evaporate during the B-stage process which occurs at temperatures lower than about 150 °C or during the formation of the film. Common solvents that readily dissolve the epoxy and phenolic resins can be used. Examples of solvents that may be utilized include esters, alcohols, ethers, and other common solvents that are stable and dissolve the epoxy and phenolic resins in the composition. Preferred solvents include propylene glycol methyl ether acetate (PGMEA). Solvents that dissolve any part of the expandable microspheres should be avoided.

A preferred embodiment of the underfill encapsulant of the present invention comprises at least one phenoxy resin, at least one expandable filler, solvent, and other ingredients as desired. The resin component of the underfill will comprise in the range of about 10 to about 60 wt % of the B-stageable composition and preferably about 20 to about 40 wt %. The expandable filler component of the underfill comprises in the range of about 0.02 to about 10 wt % of the B-stageable composition and preferably about 0.1 to about 5 wt %. Finally, optional ingredients such as surfactants, air release agents, flow additives, rheology modifiers, chemical blowing agents and adhesion promoters may be added to the composition in the range of about 0.01 wt % to about 5 wt % of the B-stageable composition.

To utilize the composition containing the expandable fillers as a B-stageable liquid, the composition is applied directly onto a panel array of chips, or an individual chip via screen-printing, spin coating, stencil printing or dispensing through a needle between rows of solder bumps. The chip(s) or having the coating is heated to an initial, B-stage temperature and the composition is B-stage solidified. Preferably, this heating results in a coating that is smooth and non-tacky and does not cause the expansion of the microspheres. The thickness of the coating is preferably approximately 15 - 30% of the diameter of the solder bumps. Following the B-stage heating, the solder bumps may be plasma etched or wiped with solvent to facilitate component recognition in a placement machine. The chips having the B-staged composition are placed on a substrate with the solder bumps located on the metal pad connections. The use of solder paste or standard flux is required to maintain correct alignment of the component, as well as to facilitate the fluxing and solder joint formation. The entire assembly is heated to a temperature of approximately 183 °C (in the case that tin/lead solder is utilized). This second heating causes the formation of interconnections between the substrate and the chip and causes the microspheres to expand and to fill the gap between the component and substrate.

To utilize the underfill encapsulant of the present invention as a laminated film, the film would be pre-cast on a carrier film and then dried at a temperature below the expansion initiation temperature of the expandable filler. Next, the film would be vacuum laminated on to the full area of the component at the softening temperature of the film. Finally, the solder would be cleaned via plasma etching, or by wiping with solvent, and the component would be ready for placement. Alternatively, the film can be pre-patterned via varying methods such as laser ablation or die-cutting into different configurations such as a grid, mesh, thin strip, or square box pattern and placed or laminated onto the component. In this way contact between the solder bump and the underfill can be avoided and hence eliminate the need for plasma etching. After placement, the component is subjected to reflow which causes the expansion of the expandable fillers into the closed-cell structures. Both the B-stageable and laminated film applications require stencil printing of the solder paste before the component is placed.

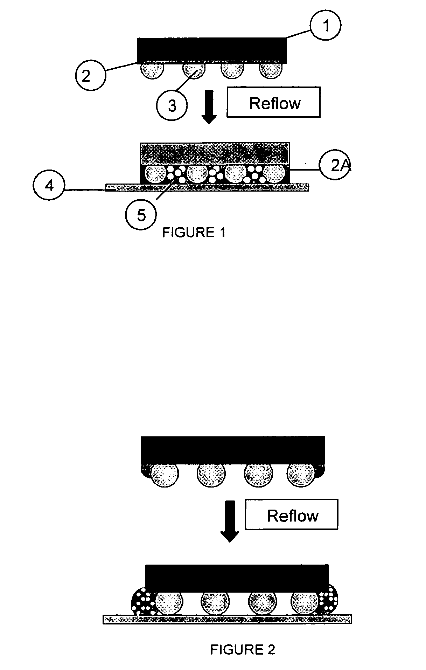

Figure 1 illustrates the expansion of the expandable fillers after reflow. Electrical component 1 is initially provided with a B-staged or film layer of underfill 2 and solder bumps 3. After reflow, the assembly of the electrical component and the substrate 4 has expanded underfill 2A that contains closed cell structures 5. In Figure 1 the underfill fills substantially all of the area in and around the solder bumps between the component and the substrate. Figure 2 illustrates an alternative underfill application in which the underfill 2 is applied to the perimeter of the component 1. The expanded underfill 2A is shown with the closed cell structures around the perimeter of the component after reflow.

The invention may be better understood by reference to the following examples:

EXAMPLE 1. Thermoplastic underfill compositions were manufactured as follows (all amounts of ingredients are indicated by weight percent). A mixture of solvent and resin is added to a mixing vessel equipped with a propeller stirrer. The expandable filler is then added and mixed for 5 - 10 minutes until homogeneous. A surfactant is then added to facilitate vacuum removal of air bubbles. The mixture is de-gassed for 5 minutes in a vacuum chamber at a pressure of >28 in Hg. The formulations of the resulting thermoplastic underfills are shown in Table 1.

**Table 1. Thermoplastic Underfill with Expandable Filler**

| Material | Formulation A | Formulation B |
|---|---|---|
| PKHS-30PMA¹ | 19.8 | 20.0 |
| Byk-A-500² | 0.05 | 0.05 |
| 098 DUX 120 | 0.2 | 0.1 |

| | | |
|---|---|---|
| 1 Phenoxy Resin, propylene glycol methyl ether acetate blend, available from Inchem 2 Air-release additive, available from BYK Chemie | | |

Formulation A was tested for various properties after B-staging, including drop resistance of a reinforced BGA assembly, and the results of those tests are set out in Table 2.

**Table 2. Performance of Underfill with Expandable Filler**

| Performance Properties | Value |
|---|---|
| Storage Modulus by DMA @25C | 97.5 Mpa |
| Peak tan -delta C | 100 |
| Storage Modulus by DMA* @25C | 112 Mpa |
| Moisture Absorption* | <0.1 % |
| Drop Performance** | 50 Drops |
| Drop Performance (No Underfill) | 5 Drops |

| | |
|---|---|
| *7 days exposure at 30C/60% relative humidity ** 2 meter height (60 mil FR-4 board, pBGA-169 component I/O 169, solder dia = 24 mil) | |

As shown in Table 2, the performance of the component is dramatically improved over the performance of the component having no underfill.

Many modifications and variations of this invention can be made without departing from its spirit and scope, as will be apparent to those skilled in the art. The specific embodiments described herein are offered by way of example only, and the invention is to be limited only by the terms of the appended claims, along with the full scope of equivalents to which such claims are entitled.

## Claims

1. An expandable thermoplastic or thermosetting underfill encapsulant for use in encapsulating one or more electronic components attached to one or more substrates with a solder that is reflowable at a reflow temperature, the underfill encapsulant consisting essentially of
a) a high molecular weight solid resin system component comprising, a thermoplastic polymer resin or a thermosetting resin and at least one catalyst and optionally at least one phenoxy-containing compound;
b) one or more expandable fillers; and
c) optionally one or more of group consisting of surfactants, coupling agents, reactive diluents, air release agents, flow additives, adhesion promoters, solvents and mixtures thereof,
wherein the underfill encapsulant expands at a temperature at or above the reflow temperature of the solder.

2. The encapsulant of claim 1, wherein the one or more expandable filler is selected from the group comprising microspheres, expandable balloons, and mixtures thereof.

3. The encapsulant of claim 2, wherein the one or more expandable fillers comprises in the range of about 0.1 wt % to about 10 wt % of the encapsulant.

4. The encapsulant of claim 2, wherein the one or more expandable fillers expand upon exposure to temperatures greater than about 150 C.

5. The encapsulant of claim 1, wherein the encapsulant is in the form of a film that is capable of pre-application on an electronic component or substrate.

6. The encapsulant of claim 5, wherein the film is capable of application on an electronic component via screen-printing, spin coating, stencil printing or dispensing through a needle.

7. The encapsulant of claim 1, wherein the high molecular weight resin system is selected from the group consisting of phenoxy resin, 3,4-epoxycyclohexylmethyl-3,4-epoxycyclohexane carboxylate, vinylcyclohexene dioxide, 3,4-epoxy-6-methyl cyclohexyl methyl-3,4-epoxycyclohexane carboxylate, dicyclopentadiene dioxide, bisphenol A epoxy resin, bisphenol F epoxy resin, epoxy novolac resin, poly(phenyl glycidyl ether)-co-formaldehyde, biphenyl type epoxy resin, dicyclopentadiene-phenol epoxy resins, naphthalene epoxy resins, epoxy functional butadiene acrylonitrile copolymers, epoxy functional polydimethyl siloxane, and mixtures thereof.

8. The encapsulant of claim 1, wherein the phenoxy-containing compound is a chain extended epoxy resin.

9. The encapsulant of claim 1, wherein the resin system comprises in the range of about 80 wt % to about 99.9 wt % of the encapsulant.

10. The encapsulant of claim 1 wherein the surfactant is selected from the group consisting of organic acrylic polymers, silicones, epoxy silicones, polyoxyethylene/polyoxypropylene block copolymers, ethylene diamine based polyoxyethylene/polyoxypropylene block copolymers, polyol-based polyoxyalkylenes, fatty alcohol-based polyoxyalkylenes, fatty alcohol polyoxyalkylene alkyl ethers and mixtures thereof.

11. The encapsulant of claim 1, wherein the optional solvent is selected from the group comprising solvents that are stable and dissolve the epoxy and/or phenoxy resins in the composition.

12. The encapsulant of claim 11, wherein the optional solvent is selected from the group comprising esters, alcohols, ethers and propylene glycol methyl ether acetate (PGMEA) and mixtures thereof.

13. The encapsulant of claim 12, wherein the optional solvent comprises propylene glycol methyl ether acetate (PGMEA) and mixtures thereof.

14. The encapsulant of claim 1, wherein the optional solvent comprises up to about 70 wt % of the encapsulant.

15. An electronic component having the expandable underfill composition of claim 1.
